Europäisches Patentamt

European Patent Office

Office européen des brevets

(11) Publication number: **0 501 407 A1**

# EUROPEAN PATENT APPLICATION

(21) Application number: **92103153.0**

(22) Date of filing: **25.02.92**

(51) Int. Cl.⁵: **H01L 23/522**, H01L 23/482

(30) Priority: **25.02.91 JP 30049/91**

(43) Date of publication of application:
**02.09.92 Bulletin 92/36**

(84) Designated Contracting States:
**DE FR GB**

(71) Applicant: **KABUSHIKI KAISHA TOSHIBA**
**72, Horikawa-Cho Saiwai-ku**
**Kawasaki-shi Kanagawa-ken(JP)**

(72) Inventor: **Iizuka, Yoshio**
**4-1-7-306 Kirigaoka, Midori-ku**
**Yokohama-shi, Kanagawa-ken(JP)**
Inventor: **Mochizuki, Masao**
**5-7-8 Kirigaoka, Midori-ku**
**Yokohama-shi, Kanagawa-ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Semiconductor integrated circuit having wirings.

(57) In a semiconductor integrated circuit having so-called air-bridge wirings, portions (9) of a surface of a semiconductor wafer (1), where a first wiring layer (2) and a second wiring layer (10) are overlapped for each other, are filled with a gas in order to insulate these two wiring layers. According to this invention, said portions filled by a gas are completely shielded by wiring materials and insulating materials.

FIG.2 (j)

## BACKGROUND OF THE INVENTION

### Field of the invention

This invention relates to a semiconductor integrated circuit which is fabricated using the air-bridge wiring technique.

### Description of the prior arts

The air-bridge wiring, which is a technique to insulate between wiring layers by gases instead of ordinary insulating films, has been developed in order to reduce the wiring capacity of a semiconductor integrated circuit which is used especially in a high frequency band.

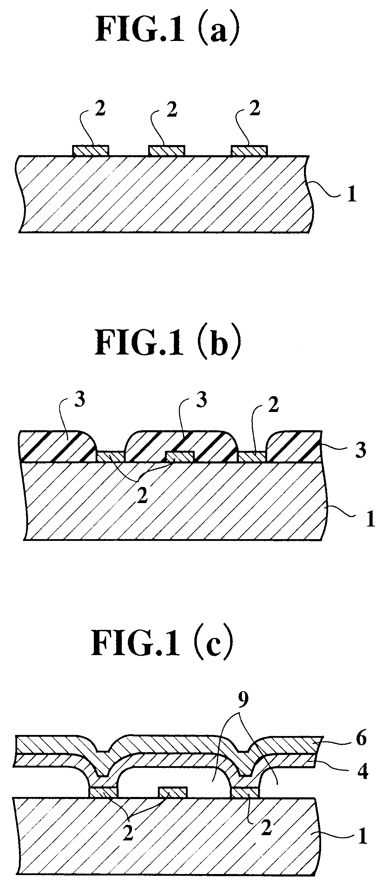

Figs. 1a to 1c illustrate a prior method for fabricating a semiconductor integrated circuit having air-bridge wirings. These figures are cross sectional views of a semiconductor wafer under steps for forming air-bridge wirings. As shown in Fig. 1a, first metal wirings 2, 2 ... are selectively formed on a semiconductor wafer 1 in which a plurality of circuit elements have been formed. Then, photo-resist 3 is coated selectively on the surface where air-bridges should be formed later, as shown in Fig. 1b. A metal thin film 4 is formed next on the surface of semiconductor wafer 1 including the parts where said photo-resist 3 is coated. On this thin film 4, a metal film 6 is formed relatively thick by a plating technique, using film 4 as an under coat. These two films 4 and 6 compose of a second wiring layer. Then, as shown in Fig. 1c, photo-resist 3 is removed from the surface of wafer 1 to form air-bridges 9.

In the above mentioned prior art, however, the mechanical strength of the second wiring layer is not enough especially in the parts where said air-bridges 9 are formed. Furthermore, in order to maintain a gas within said air-bridges, an ordinal protection film cannot be formed on the surface of the wafer, once the first and the second wiring layers have been formed. As a result, integrated circuit products obtained from the semiconductor wafer are not easy to handle. And, a plastic package product cannot be realized from this wafer. Because of these two points, the reliability of the product is not high enough for the real use.

In recent years, semiconductor integrated circuits have become widely used in civil applications in which high frequency bands above 1 G Hz are utilized. It is also highly desired to make integrated circuits small. In order to meet these requirements, the development of air-bridge products in which plastic mold is possible is highly desired. However, because of the reasons mentioned above, such products have not been obtained yet.

## SUMMARY OF THE INVENTION

This invention has been made to overcome the above mentioned problems of the prior art semiconductor integrated circuits having air-bridge wirings.

Therefore, one objective of this invention is to provide a semiconductor integrated circuit having air-bridge wirings, which have enough mechanical strength.

Another objective of this invention is to provide a semiconductor integrated circuit having air-bridge wirings, which have a new structure so as to realize a plastic mold of a package with high reliability.

Still other objective of this invention is to provide a new method for forming air-bridge wirings on a semiconductor wafer, the wirings which have enough mechanical strength and which can be shielded by an insulating layer formed thereon.

The first aspect of this invention provides a semiconductor integrated circuit having air-bridge wirings, the circuit which is comprised of the following: a semiconductor wafer having a plurality of circuit elements on its main surface; a first wiring layer provided on said surface in order to connect some of said circuit elements; a second wiring layer provided on said surface in order to connect some of said circuit elements; a gas which is filled between said first and second wiring layers and to insulate these two layers at places where said two wiring layers are overlapped to each other; an insulating layer formed on said second wiring layer; and wherein said insulating layer is formed to shield said gas filled portions in co-operation with said second wiring layer.

The second aspect of this invention provides a method for fabricating a semiconductor integrated circuit having air-bridge wirings, which is comprised of the following steps: a) forming a plurality of circuit elements on a semiconductor wafer; b) forming a first wiring layer to connect some of said circuit elements; c) coating a photo-resist material on the portions of said first wiring layer where said air-bridges should be formed; d) forming a second wiring layer on predetermined areas of the surface of said semiconductor wafer including the portions where said photo-resist material is coated; e) removing said photo-resist material and also a part of said second wiring layer formed on said photo-resist material, in order to form said air-bridges; f) forming a first insulating film on the whole surface of said semiconductor wafer, after said photo-resist material formed at step c) is removed; and g) forming a second insulating film, which is relatively thick, onto said first insulating film under a desired gas pressure so as to shield said air-bridges completely in co-operation with said second wiring layer and said first insulating film.

According to said first aspect of this invention, the semiconductor integrated circuit having air-bridge wirings is covered completely by said insulating layer and said second wiring layer, thus enabling to strengthen and shield said air-bridge portions. As a result, a plastic package product having enough mechanical strength is obtained from the semiconductor integrated circuit of this invention.

According to said second aspect of this invention, said first insulating film is formed on the whole surface of the semiconductor wafer which is undergone the processes to make first and second wiring layers. This film is, however, very thin, so that air-bridge portions are not shielded completely with this film. Then, the second insulating film is formed on said first insulating film under a desired gas pressure, so as to shield said air-bridge portions completely. As a result, said air-bridge portions are shielded completely with holding the gas for a desired pressure.

These and other objectives, features, and advantages of the present invention will be more apparent from the following detailed description of preferred embodiments in conjunction with the accompanying drawings.

BRIEF DESCRIPTION OF THE DRAWINGS

Figs. 1a to 1c illustrate the fabrication steps for forming air-bridge wirings on a semiconductor wafer according to a prior art method of this invention; and
Figs. 2a to 2j show the fabrication steps for forming air-bridge wirings on a semiconductor wafer according to one embodiment of the present invention.

DETAILED DESCRIPTION OF PREFERRED EMBODIMENTS

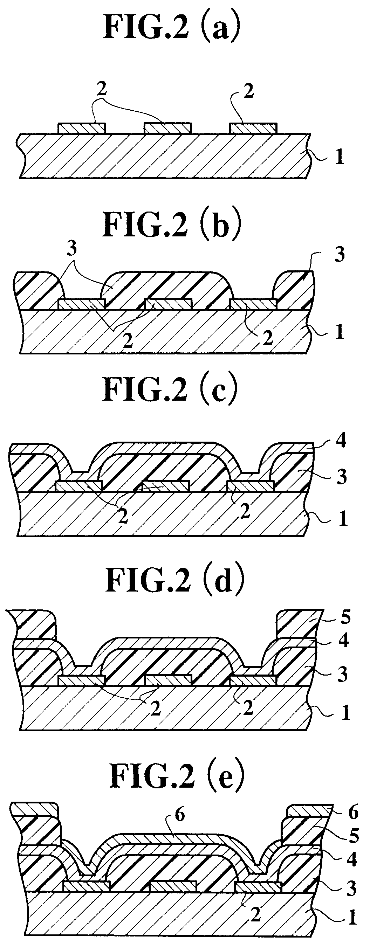

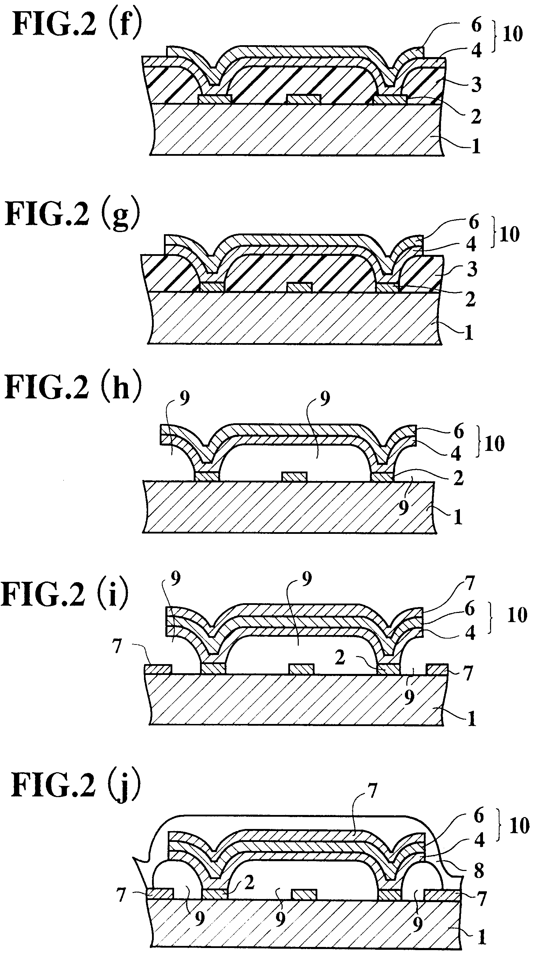

A fabrication method of a semiconductor integrated circuit according to one embodiment of the present invention will be described below by referring to Figs. 2a to 2j. This explanation will be focused especially on how to form air-bridge wirings on a semiconductor wafer, and so, other fabrication steps, such as how to make semiconductor elements on the wafer etc., are omitted.

First, as shown in Fig. 2a, a first wiring layer 2, which connect a plurality of semiconductor elements ( not shown ) formed on a semiconductor wafer 1, is formed on the surface of wafer 1. Next, as shown in Fig. 2b, a first photo-resist film 3 in which appartures are provided only on the parts where first wiring layer 2 and a second wiring layer ( described later ) come in contact for each other, is formed. A metal ( such as Ti ) thin film 4 is, then, formed on photo-resist film 3 as shown in Fig. 2c. This film 4 will become an under coat for the second wiring layer. Then, as shown in Fig. 2d, a second photo-resist film 5 is coated on metal thin film 4. This film 5 has appartures only where the second wiring will be formed. In Fig. 2e, a metal ( for example, Al ) thin film 6 is formed on second photo-resist film 5 and said appartures. This film 6 is the upper layer of the second wiring layer. In this case, film 6 should be formed discontinuously between the part formed on second photo-resist film 5 and the other part formed on thin film 4. Therefore, film 6 is made thicker than said thin film 4, but also thinner enough than said second photo-resist film 5.

Second photo-resist film 5 is then removed as shown in Fig. 2f. At the same time, parts of second metal film 6 formed on second photo-resist film 5 are also removed. Using second metal film 6 as a mask for etching, exposed portions of first metal film 4, which were made at the step shown in Fig. 2f, are removed by etching as shown in Fig. 2g, to form the second wiring layer 10. Then, first photo-resist film 3 is removed by etching as shown in Fig. 2h, in order to form so-called air-bridges 9. An insulating film 7 ( $SiO_2$ ) is formed next on the whole surface of the wafer 1 by a vacuum evaporation, as shown in Fig. 2i. In this case, however, said air-bridges should not be closed completely by this insulating film 7. After this, as shown in Fig. 2j, an upper insulating film 8 ( $SiO_2$ ) is formed by a CVD method under the condition of an ordinary atmospheric pressure so as to close said air-bridges completely. During this step, wafer 1 is kept at a desired gas pressure. Consequently, air-bridges 9 are shielded with holding the gas in the desired pressure.

In summary, according to the present invention, insulating protection films are formed on a semiconductor wafer having air-bridge wirings, allowing the air-bridge portions to be a desired pressure. As a result, unlike the prior art, air-bridge portions are shielded by said insulating films. So, the surface of a semiconductor pellet can be protected from outside atmospher and the mechanical strength of air-bridge portions can be greatly improved. Furthermore, the plastic mold of a product has become possible for this semiconductor integrated circuit, thus greatly improving the reliability of the product.

Various modifications will become possible for those skilled in the art after receiving the teachings of the present disclosure without departing from the scope thereof.

**Claims**

**1.** A semiconductor integrated circuit having air-bridge wirings, comprising:

a semiconductor wafer having a plurality of circuit elements on its main surface;

a first wiring layer provided on said surface in order to connect some of said circuit elements;

a second wiring layer provided on said surface in order to connect some of said circuit elements;

a gas which is filled between said first and second wiring layers and to insulate these two layers at places where said two wiring layers are overlapped to each other;

an insulating layer formed on said second wiring layer; and

wherein said insulating layer is formed to shield said gas filled portions in co-operation with said second wiring layer.

2. The semiconductor integrated circuit as claimed in Claim 1, wherein said second wiring layer is comprised of two metal thin films.

3. The semiconductor integrated circuit as claimed in Claim 2, wherein said two metal thin films are made of Ti and Al respectively.

4. The semiconductor integrated circuit as claimed in Claim 1, wherein said insulating layer includes an under coat film formed on said second wiring layer.

5. The semiconductor integrated circuit as claimed in Claim 1, wherein said insulating layer is made of SiO2.

6. The semiconductor integrated circuit as claimed in Claim 4, wherein said under coat film is made of SiO2.

7. A method for fabricating a semiconductor integrated circuit having air-bridge wirings, comprising the steps of:

a) forming a plurality of circuit elements on a semiconductor wafer;

b) forming a first wiring layer to connect some of said circuit elements;

c) coating a photo-resist material on the portions of said first wiring layer where said air-bridges should be formed;

d) forming a second wiring layer on predetermined areas of the surface of said semiconductor wafer including the portions where said photo-resist material is coated;

e) removing said photo-resist material and also a part of said second wiring layer formed on said photo-resist material, in order to form said air-bridges;

f) forming a first insulating film on the whole surface of said semiconductor wafer, after said photo-resist material formed at step c) is removed; and

g) forming a second insulating film, which is relatively thick, onto said first insulating film under a desired gas pressure so as to shield said air-bridges completely in co-operation with said second wiring layer and said first insulating film.

8. The method for fabricating a semiconductor integrated circuit as claimed in Claim 7, wherein said first insulating film is made of $SiO_2$ deposited by a vacuum evaporation method at step e), and said second insulating film is made of $SiO_2$ deposited by a CVD method under an ordinary atmospheric pressure at step f).

# FIG.1 (a)

# FIG.1 (b)

# FIG.1 (c)

# FIG.2 (a)

# FIG.2 (b)

# FIG.2 (c)

# FIG.2 (d)

# FIG.2 (e)

FIG.2 (f)

FIG.2 (g)

FIG.2 (h)

FIG.2 (i)

FIG.2 (j)

7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-3 890 636 (HITACHI LTD.)<br>* column 10, line 20 - line 39 *<br>* column 14, line 5 - line 10; figure 5 * | 1 | H01L23/522<br>H01L23/482 |
| A | | 2-8 | |
| | --- | | |
| A | EP-A-0 309 805 (NEC)<br>* column 4, line 36 - line 42 *<br>* column 6, line 30 - line 39 * | 1-3,7 | |
| | --- | | |
| A | EP-A-0 343 269 (FAIRCHILD)<br><br>* column 11, line 40 - line 50; claims 1,8,17; figure 2 * | 1-3,5,7,8 | |
| | ----- | | |

| | |
|---|---|
| | TECHNICAL FIELDS SEARCHED (Int. Cl.5)<br><br>H01L |

The present search report has been drawn up for all claims

| Place of search | Date of completion of the search | Examiner |
|---|---|---|
| THE HAGUE | 02 JUNE 1992 | DE RAEVE R.A.L. |